# EUROPEAN PATENT SPECIFICATION

(11) **EP 1 996 666 B1**
(45) Date of publication and mention of the grant of the patent: **04.06.2014**
(21) Application number: 07748813.8
(22) Date of filing: 03.01.2007
(51) Int. Cl.: C09K 3/00, C23F 11/00

(54) **PRECOAT COMPOSITION FOR ORGANIC SOLDERABILITY PRESERVATIVE**
VORBESCHICHTUNGSZUSAMMENSETZUNG FÜR ORGANISCHE PASSIVIERUNG
COMPOSITION DE PRE-ENDUIT POUR CONSERVER L'APTITUDE AU SOUDAGE ORGANIQUE

(30) Priority: 22.03.2006 US 386901
(43) Date of publication of application: 03.12.2008
(73) Proprietor: MacDermid, Incorporated, Waterbury, CT 06702 (US)
(72) Inventor: LARSON, Brian, Cheshire, CT 06410 (US); PAW, Witold, New Fairfield, CT 06812 (US)
(74) Representative: Jenkins, Peter David
(86) International application number: PCT/US2007/000015
(87) International publication number: WO 2007/111757

(56) References cited:
- EP-A1- 0 428 383
- EP-A1- 0 855 454
- WO-A1-01/14612
- US-A- 5 238 550
- US-A- 5 532 094
- US-A- 5 560 785
- US-A- 5 658 611
- US-A- 5 658 611
- US-A- 5 679 266

## Description

### FIELD OF THE INVENTION

The present invention is directed to an organic solderability preservative process for coating copper circuitry during printed wiring board manufacture. The improved process of the invention comprises the use of a pre-coat coating prior to the main organic solderability preservative bath to enhance solderability of the copper surfaces.

### BACKGROUND OF THE INVENTION

In the manufacture of printed wiring boards (PWB) having metal containing components which are to be soldered, it is necessary to protect the metal from oxidation to enhance its solderability. Typically, many such electronic components have copper circuitry thereon and may also have gold leads or other electrical connections which are generally used to connect the electronic component to other electronic components.

Processes currently used to protect copper prior to soldering typically employ a protective coating deposited on the copper. Prior art processes include hot air solder leveling (HASL), organic solderability preservatives (OSP) and other metallic printed circuit board surface finishes. The protective coating provides protection against copper solderability degradation caused by various process steps in the fabrication process.

Copper protective coating systems utilize a number of steps including cleaning, microetching and acid rinsing followed by the formation of a protective coating on the copper using a solution containing a protective forming agent.

In general, the surface of the copper or copper alloy is first cleaned by immersion of the board in a cleaner and then preferably etched to increase the adhesion of the copper. The copper is then immersed in a solution containing an organic solderability preservative material such as triazole, imidazole, benzimidazole or derivatives thereof. Spraying or other forms of coating may also be used.

Cleaning of the PWB may be performed using any number of cleaners including alkaline, acid or neutral cleaners and is preferably an acidic cleaner comprising sulfuric acid, hydrochloric acid or citric acid. The PWB is typically contacted with the cleaner for up to about 5 minutes at a temperature of 80° to 120° F.

An etchant is preferably used to microetch the surface of the copper. Etchants such as an acidified persulfate salt such as sodium persulfate or sulfuric/peroxide type material at 70°-100° F for about 1 min. are typically employed.

All the steps in the conventional OSP process are followed by rinsing the substrate typically with deionized water. Rinsing is usually performed at an ambient temperature.

Organic solderability protective coatings typically comprise a material such as a triazole, an imidazole or benzimidazole, or a derivative thereof. The substrate is treated with the OSP solution to form a protective layer on the copper metallurgy. This is usually performed at a temperature of 95° to 115° F, preferably about 105° to 110° F for about 15 seconds to 1 minute.

A number of patents have been issued for OSP coatings with an objective of providing protective coatings that are more uniform and have a better appearance, and with the goal of also improving solderability.

U.S. Pat. No. 5,658,611 to Ishido et al., provides an aqueous surface protection composition for PWB's containing a benzimidazole derivative that is adjusted to a pH of 1-5 with a salt forming acid of a heavy metal such as copper, manganese and zinc in an amount of less than 50 ppm.

U.S. Pat. No. 5,173,130 to Kinoshita et al., describes a process for the surface treatment of copper which comprises immersing the surface of the copper in an aqueous solution containing a benzimidazole compound having an alkyl group of at least three carbon atoms at the 2-position and an organic acid. Similarly, in U.S. Pat. Nos. 5,498,301 and 5,560,785 to Hirao et al., the subject matter of each of which is herein incorporated by reference in its entirety, describe a water-based surface treatment agent used to protect copper on a printed wiring board with excellent heat-resistance and moisture-resistance which uses a 2-arylimidazole compound as an active ingredient.

U.S. Pat. No. 5,362,334 to Adams et al., describes a composition and process for the surface treatment of metallic surfaces such as copper circuitry on printed circuit boards which comprises treating the surface with an aqueous solution comprising a benzimidazole compound having either a halogenated phenyl group, a halogenated benzyl group or a halogenated ethyl phenyl group in the 2-position.

U.S. Pat. No. 5,376,189 to Kukanskis, describes a composition and process for the treatment of metallic surfaces such as copper on printed circuit boards which comprises treating the surface with an aqueous solution comprising a benzimidazole compound which has at least one carboxylic or sulfonic acid group directly or indirectly attached to the benzimidazole compound. The carboxylic acid or sulfonic acid group was believed to increase the solubility of the benzimidazole which provides for longer bath life and ease of operation.

U.S. Patent No. 6,635,123 to Cavallotti et al., provides for the addition of zinc salts in the OSP solution to improve copper surface characteristics. The addition of the zinc salts causes surface oxidation to decrease, both during soldering and during exposure to the atmosphere, and improves the wettability of the copper surface, even after extended periods at elevated temperatures. In addition, the addition of the zinc salts improves the adhesion of the tin solder alloy to the surface.

US 5,560,785 discloses a water-based surface treatment agent used to provide a chemical layer on a copper or copper alloy printing wiring board.

US 5,679,266 discloses a method of assembling a printed circuit board with ultrafine pitch components.

Other prior art processes have suggested forming a precoating layer on the copper surface prior to applying the final protective coating. For example, U.S. Patent No. 4,373,656 to Parker, Jr. et al., describes a method for treating bare copper printed circuit boards comprising first subjecting the copper surfaces to a mild etch solution, stabilizing the surfaces by treatment with an aqueous solution of phosphoric acid in combination with a glycol and subsequently treating the surface with an azole (e.g., imidazole).

U.S. Patent No. 6,524,644 to Wengenroth, provides a pre-treatment step before the OSP coating to provide an enhanced final protective coating, comprising a benzimidazole compound and an alkanolamine. The pretreatment coating described by Wengenroth is believed to preserve the solderability of the copper surface while substantially excluding gold surfaces from attracting the OSP coating, which could case cosmetic defects in the form of staining and possibly reduce the conductivity of the gold contact surface.

The inventors of the present invention have determined that additional improvements to the OSP coating process can be made that produce a more uniform coating having a better appearance and color. To that end, the inventors of the present invention have developed a method according to claim 1. Once a substrate has been coated with the pretreatment composition, the substrate can be processed in the normal manner (i.e., coated with an OSP comprising an azole compound).

### SUMMARY OF THE INVENTION

It is an object of the present invention to provide an improved OSP coating process that uses a pretreatment composition prior to the OSP coating.

It is another object of the present invention to use the improved OSP coating process of the invention to prepare electronic components such as printed wiring boards.

To that end, the present invention is directed to a method of enhancing the solderability of a copper surface comprising the steps of:
a) contacting one or more copper surfaces with a pretreatment composition comprising a solution of an aliphatic carboxylic acid and an additive selected from the group consisting of amines and ammonia; and thereafter
b) contacting the copper surface with an organic solderability preservative composition, comprising an aqueous solution of one or more materials selected from the group consisting of substituted or unsubstituted triazoles, substituted or unsubstitued imidazoles, substituted or unsubstituted benzimidazoles, substituted or unsubstitued benzatriazoles and substituted or unsubstitued azoles.

### DETAILED DESCRIPTION OF THE PREFERRED EMBODIMENTS

The present invention is directed to an improved protective coating system for coating copper metallurgy on printed wiring boards (PWB's) including copper pads and through holes.

In the present invention, a conventional azole-based OSP coating is improved by using a pre-treatment step, wherein the copper surfaces are contacted with a pre-treatment solution comprising an aliphatic carboxylic acid and an amine before the OSP treatment. The inventors of the present invention have found that the use of the pretreatment composition of the invention enhances the final protective coating on the copper surfaces and provides a more uniform coating that also has a better appearance and color.

More particularly, the present invention is directed to a method of enhancing the solderability of a copper surface comprising the steps of:
a) contacting one or more copper surfaces with a pretreatment composition comprising a dilute solution of an aliphatic carboxylic acid and an additive selected from the group consisting of amines and ammonia; and thereafter
b) contacting the copper surface with an organic solderability preservative composition.

The improved pretreatment layer of the invention is preferably a dilute mixture of an aliphatic carboxylic acid and an additive selected from amines and ammonia, although amines are generally most preferred. The aliphatic carboxylic acid is preferably of the C5-C9 chain length, including pentanoic acid, hexanoic acid, heptanoic acid, octanoic acid, and nonanoic acid. In a preferred embodiment, the aliphatic carboxylic acid is heptanoic acid. If used, the amine is typically selected from the group consisting of triethanolamine, dimethylamine, dipropylamine, diethanolamine, ammonia, and ethanolamine. In a preferred embodiment, the amine is triethanolamine or a similar compound.

One example of a solution that is usable in the practice of the invention is a dilute solution of heptanoic acid and triethanolamine at approximately 1 g/l each. Such solution is preferably approximately equimolar, i.e., contains about the same number of molecules of each component, and can be viewed as a solution of a salt between the triethanolamine and the heptanoic acid, with a pH of approximately 6. Preferably the concentration of the aliphatic carboxylic acid and the amine in the solution can be varied between about 1 g/l to about 10 g/l for each ingredient, preferably from about 1 g/l to about 5 g/l for each ingredient. Varying the ratio of acid and amine, and thus modifying the pH between about 4.5 and 9.5 is practical in the practice of this invention. A copper surface of a PCB leaving the precoat is hydrophobic, indicating the formation of a film. This film may be thinned, modified or desorbed during rinsing as evidenced by loss of hydrophobicity of the copper surface.

The pretreatment composition of the invention can be used at room temperature or higher. Preferably, the step of contacting the electronic component with the pretreatment composition comprises immersing the electronic component in the pretreatment composition. In this case, the dwell time of the electronic component in the solution can be between 1 and 5 minutes, preferably about 1 to 2 minutes.

A rinsing step may also be performed between the pretreatment step and the organic solderability preservative step to remove excess pretreatment solution.

A number of OSP solutions have been developed which may be used to form the OSP coating, examples of several of which have been cited herein. However, any suitable OSP solution described in the prior art may be used to provide the final coating on the substrate metallurgy. Preferably, the organic solderability preservative comprises at least one azole, and more preferably, the azole is an imidazole.

The pretreatment composition and step of this invention is followed, preferably after rinsing, with the application of an organic solderability preservative. The organic solderability preservative is preferably an aqueous solution of a substituted or unsubstituted triazole, substituted or unsubstituted imidazole, substituted or unsubstituted benzimidozole, substituted or unsubstituted benzotriazole and/or substituted or unsubstituted azole. The inventors have found that imidazoles or benzimidazoles substituted with an alkyl group in the 2-position or the 5-position are most beneficial. 5-methyl Benzimidazole is particularly preferred. The concentration of the foregoing azoles in the aqueous OSP solution is preferably from 0.5 to 50 g/l and the pH is preferably from about 3 to 11. The copper surface is contacted with the OSP solution by immersion, spray or flood at from room temperature to about 180°F.

The benefit of using the precoat of the invention is a better organic solderability preservative coating, which provides a more uniform coating and that also has a better appearance. As a result, solderability is also better.

After the OSP treatment, the substrate is rinsed and typically dried by dry forced air. The substrate may then be soldered and is protected against oxidation until the soldering step is performed.

It can thus be seen that the present invention provides an improved solderable copper surface by using a novel precoat composition prior to an organic solderability preservative.

## Claims

1. A method of enhancing the solderability of a copper surface comprising the steps of:
a) contacting the copper surface with a pretreatment composition comprising a solution of an aliphatic carboxylic acid and an additive selected from the group consisting of amines and ammonia; and thereafter
b) contacting the copper surface with an organic solderability preservative composition comprising an aqueous solution of one or more materials selected from the group consisting of substituted or unsubstituted triazoles, substituted or unsubstituted imidazoles, substituted or unsubstituted benzimidazoles, substituted or unsubstituted benzotriazoles, and substituted or unsubstituted azoles.

2. The method according to claim 1, wherein the aliphatic carboxylic acid is selected from the group consisting of carboxylic acids with from 5 to 9 carbons.

3. The method according to claim 2, wherein the aliphatic carboxylic acid comprises heptanoic acid.

4. The method according to claim 1, wherein the additive is used and comprises an amine which is selected from the group consisting of triethanolamine, dimethylamine, dipropylamine, diethanolamine, ammonia, and ethanolamine.

5. The method according to claim 4, wherein the amine is triethanolamine.

6. The method according to claim 4, wherein the aliphatic carboxylic acid and the amine are each present in the pretreatment composition at a concentration between 1 to 10 g/l.

7. The method according to claim 1, wherein the pH of the pretreatment solution is between 4.5 and 9.5.

8. The method according to claim 7, wherein the pH of the pretreatment solution is about 6.0.

9. The method according to claim 1, wherein a rinsing step is performed between the pretreatment step and the organic solderability preservative step.

10. The method according to claim 1, wherein said step of contacting the copper surface with the pretreatment composition comprises immersing the copper surface in the pretreatment composition.

11. The method according to claim 10, wherein the copper surface is immersed in the pretreatment composition for 1 to 5 minutes.

12. The method according to claim 1, wherein the organic solderability preservative composition comprises at least one azole.

13. The method according to claim 12, wherein the at least one azole is an imidazole.

## Patentansprüche

1. Verfahren zum Verbessern der Lötbarkeit einer Kupferoberfläche, die folgenden Schritte umfassend:
a) Inkontaktbringen der Kupferoberfläche mit einer Vorbehandlungszusammensetzung, die eine Lösung aus einer aliphatischen Carbonsäure und einem Additiv aufweist, das ausgewählt ist aus der Gruppe bestehend aus Aminen und Ammoniak; und danach
b) Inkontaktbringen der Kupferoberfläche mit einer organischen Lötbarkeit-erhaltenden Zusammensetzung, die eine wässrige Lösung aus einem oder mehreren Materialien umfasst, die ausgewählt sind aus der Gruppe bestehend aus substituierten oder unsubstituierten Triazolen, substituierten oder unsubstituierten Imidazolen, substituierten oder unsubstituierten Benzimidazolen, substituierten oder unsubstituierten Benzotriazolen und substituierten oder unsubstituierten Azolen.

2. Verfahren nach Anspruch 1, wobei die aliphatische Carbonsäure ausgewählt ist aus der Gruppe bestehend aus Carbonsäuren mit 5 bis 9 Kohlenstoffatomen.

3. Verfahren nach Anspruch 2, wobei die aliphatische Carbonsäure Heptansäure umfasst.

4. Verfahren nach Anspruch 1, wobei das Additiv verwendet wird und ein Amin umfasst, das ausgewählt ist aus der Gruppe bestehend aus Triethanolamin, Dimethylamin, Dipropylamin, Diethanolamin, Ammoniak und Ethanolamin.

5. Verfahren nach Anspruch 4, wobei das Amin Triethanolamin ist.

6. Verfahren nach Anspruch 4, wobei die aliphatische Carbonsäure und das Amin jeweils in einer Konzentration zwischen 1 bis 10 g/l in der Vorbehandlungszusammensetzung vorhanden sind.

7. Verfahren nach Anspruch 1, wobei der pH der Vorbehandlungslösung zwischen 4,5 und 9,5 liegt.

8. Verfahren nach Anspruch 7, wobei der pH der Vorbehandlungslösung etwa 6,0 ist.

9. Verfahren nach Anspruch 1, wobei ein Spülschritt zwischen dem Vorbehandlungsschritt und dem organischen Lötbarkeit-erhaltenden Schritt durchgeführt wird.

10. Verfahren nach Anspruch 1, wobei der Schritt des Inkontaktbringens der Kupferoberfläche mit der Vorbehandlungszusammensetzung das Eintauchen der Kupferoberfläche in die Vorbehandlungszusammensetzung beinhaltet.

11. Verfahren nach Anspruch 10, wobei die Kupferoberfläche 1 bis 5 Minuten lang in die Vorbehandlungszusammensetzung eingetaucht wird.

12. Verfahren nach Anspruch 1, wobei die organische Lötbarkeiterhaltende Zusammensetzung mindestens ein Azol aufweist.

13. Verfahren nach Anspruch 12, wobei das mindestens eine Azol Imidazol ist.

## Revendications

1. Procédé pour améliorer l'aptitude au soudage d'une surface de cuivre comprenant les étapes suivantes :
a) mettre en contact la surface de cuivre avec une composition de prétraitement comprenant une solution d'un acide carboxylique aliphatique et d'un additif sélectionné dans le groupe comprenant les amines et l'ammoniac ; et ensuite
b) mettre en contact la surface de cuivre avec une composition de conservation d'aptitude au soudage organique comprenant une solution aqueuse d'un ou plusieurs matériaux sélectionnés dans le groupe comprenant les triazoles substitués ou non substitués, les imidazoles substitués ou non substitués, les benzimidazoles substitués ou non substitués, les benzotriazoles substitués ou non substitués, and les azoles substitués ou non substitués.

2. Procédé selon la revendication 1, dans lequel l'acide carboxylique aliphatique est choisi dans le groupe comprenant les acides carboxyliques ayant 5 à 9 atomes de carbone.

3. Procédé selon la revendication 2, dans lequel l'acide carboxylique aliphatique comprend de l'acide heptanoïque.

4. Procédé selon la revendication 1, dans lequel l'additif est utilisé et comprend une amine sélectionnée dans le groupe comprenant la triéthanolamine, la diméthylamine, la dipropylamine, la diéthanolamine, l'ammoniac, et l'éthanolamine.

5. Procédé selon la revendication 4, dans lequel l'amine est la triéthanolamine.

6. Procédé selon la revendication 4, dans lequel chacun de l'acide carboxylique aliphatique et de l'amine est présent dans la composition de prétraitement à une concentration comprise entre 1 et 10 g/litre.

7. Procédé selon la revendication 1, dans lequel le pH de la solution de prétraitement est compris entre 4,5 et 9,5.

8. Procédé selon la revendication 7, dans lequel le pH de la solution de prétraitement est d'environ 6,0.

9. Procédé selon la revendication 1, dans lequel une étape de rinçage est réalisée entre l'étape de prétraitement et l'étape de conservation d'aptitude au soudage organique.

10. Procédé selon la revendication 1, dans lequel l'étape consistant à mettre en contact la surface de cuivre avec la composition de prétraitement comprend une immersion de la surface de cuivre dans la composition de prétraitement.

11. Procédé selon la revendication 10, dans lequel la surface de cuivre est immergée dans la composition de prétraitement pendant 1 à 5 minutes.

12. Procédé selon la revendication 1, dans lequel la composition de conservation d'aptitude au soudage organique comprend au moins un azole.

13. Procédé selon la revendication 12, dans lequel ledit au moins un azole et un imidazole.
